# EUROPEAN PATENT APPLICATION

(11) **EP 2 234 164 A1**
(43) Date of publication of application: **29.09.2010**
(21) Application number: 08861617.2
(22) Date of filing: 15.12.2008
(51) Int. Cl.: H01L 31/02, H01L 33/00, H01S 5/022

(54) **CAN TYPE OPTICAL MODULE**

(30) Priority: 18.12.2007 JP 2007325399
(71) Applicant: NEC Corporation, Minato-ku Tokyo 108-8001 (JP)
(72) Inventor: CHIKUMA, Tadayuki, Tokyo 108-8001 (JP)
(74) Representative: Betten & Resch
(86) International application number: PCT/JP2008/072782
(87) International publication number: WO 2009/078384

(57) **Abstract**

A CAN type optical module according to the present invention includes a stem (201) including an insulating first plate-shaped member (201b) having an optical component (102) mounted on an inner surface thereof and a conductive second plate-shaped member (201a) having an opening and being fixed with the first plate-shaped member (201b) so as to cover the opening. A conductive CAN member (103) is fixed to the second plate-shaped member 201a so as to include the optical component (102) provided on the first plate-shaped member (201b). A plurality of lead terminals (203) are electrically connected with respective electrical wires from the optical component (102) and are fixed to an outside of the first plate-shaped member (201b).

## Description

### Technical Field

The present invention relates to a CAN type (CAN-TYP) optical module having a CAN package structure.

### Background Art

Optical interfaces for use in ultrahigh-speed optical communication systems are each provided with an optoelectronic element for performing conversion between an optical signal and an electrical signal. CAN type optical modules each having such an optoelectronic element hermetically sealed therein are widely used. The structure of such a CAN type optical module will be briefly described below.

Fig. 4 is a side sectional view schematically showing a structure of a CAN unit in a CAN type optical module. A CAN unit 110 includes a stem 101, an optical component 102, and a lens-equipped holder 103 serving as a CAN package. The stem 101 is mounted with lead terminals 105 through a glass sealing portion 107. The optical component 102 composed of an optical element or the like is mounted on a mounting portion of the stem 101.

The lens-equipped holder 103 is mounted with a ball lens 104 by glass sealing. The ball lens 104 maintains a positional relationship of light beams to be focused on the optical component 102 between the ball lens and the optical component 102. The stem 101 and the lens-equipped holder 103 are joined together by resistance welding with a resistance welding portion 106. Accordingly, a signal ground (hereinafter, referred to as "signal GND") of the optical component 102 mounted to the stem 101 is electrically connected to the lens-equipped holder 103 through the resistance welding portion 106.

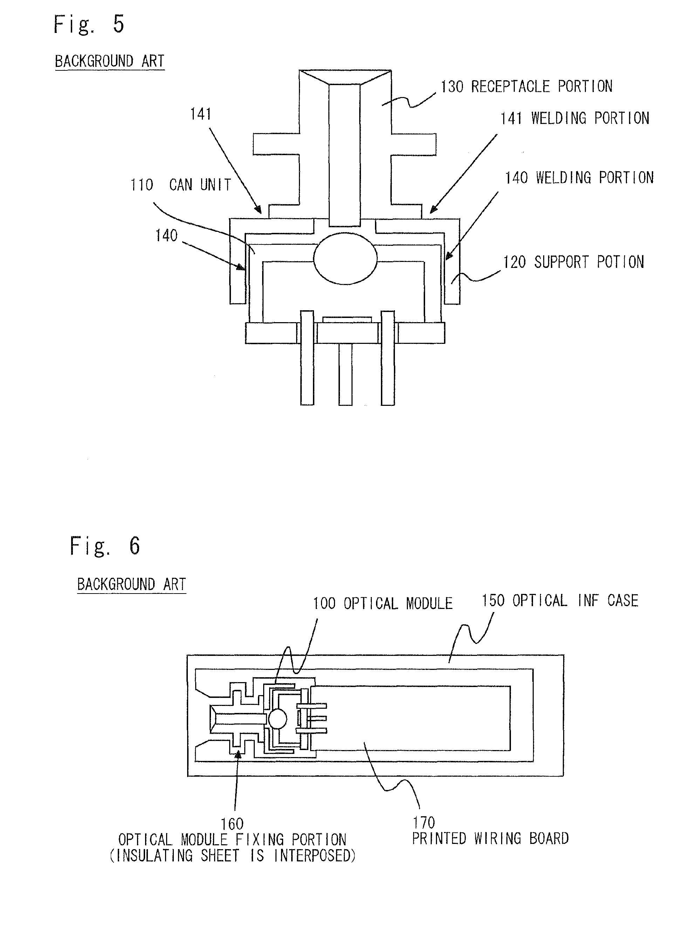

Fig. 5 is a side sectional view showing an overall configuration example of the CAN type optical module. The CAN unit 110 is joined by welding to a support potion 120 with a welding portion 140. The support potion 120 is also joined by welding to a receptacle portion130 with a welding portion 141. As described above, the signal GND of the optical component 102 is connected in common to the lens-equipped holder 103. Accordingly, a CAN type optical module 100 is in the state in which the entire GND is not separated into a signal GND and a frame GND.

Fig. 6 is a side sectional view showing a schematic configuration of an optical interface having the CAN type optical module installed in an interface (INF) case. The optical module 100 fabricated by welding the support potion 120 and the receptacle portion 130 to the CAN unit 110 is installed in an INF case 150 through an optical module fixing portion 160.

In the optical module fixing portion 160, an insulating material, such as an insulating sheet, for providing electrical isolation from the optical module 100 is interposed. The INF case 150 serves as a frame ground (GND). Accordingly, the INF case 150 (frame GND) and the optical module 100 are isolated from each other by the insulating sheet, thereby achieving isolation between the frame GND and the signal GND.

Further, Patent Document 1 discloses a CAN type optical module achieving high-speed signal transmission with low noise. In the optical module, a ceramic substrate having a high-speed signal wire formed therein is made to penetrate through a stem of a CAN package, thereby making it possible to mount electronic components, such as a driver LSI (Large Scale Integration) and an amplification LSI, near a light receiving/emitting element in the CAN package.

[Patent Document 1]
Japanese Unexamined Patent Application Publication No. 2003-229629

### Disclosure of Invention

### Technical Problem

When the optical module 100 including the CAN unit shown in Fig. 4 is incorporated into the INF case 150, however, it is necessary to isolate the GND by winding an insulating tape around the optical module fixing portion 160. In this method, the winding of the tape makes the mounting unstable, which makes it difficult to perform positioning with high accuracy as required by the receptacle portion 130 that is a kind of optical connector. This causes a stress to be exerted on the optical module 100 and variations in mounting position.

Further, in the optical module disclosed in Patent Document 1, a ceramic substrate having a high-speed signal wire formed therein is made to penetrate through a stem, thereby making it possible to mount various electronic components near a light receiving/emitting element. Accordingly, the ceramic substrate does not have a function as a stem. Thus, there is a drawback that it is necessary to fix a separate metal stem to the ceramic substrate so as to secure the accuracy of the optical axis of the optical element, which results in a complicated configuration.

The present invention has been made in view of the above circumstances and has an object to provide a CAN type optical module capable of suppressing variations in mounting position and a stress.

### Technical Solution

A CAN type optical module according to the present invention includes: a stem including an insulating first plate-shaped member having an optoelectronic element mounted on an inner surface thereof and a conductive second plate-shaped member having an opening and being fixed with the first plate-shaped member so as to cover the opening; a conductive CAN member fixed to the second plate-shaped member so as to include the optoelectronic element provided on the first plate-shaped member; and a plurality of lead terminals electrically connected to respective electric wires from the optoelectronic element and fixed to an outside of the first plate-shaped member.

### Advantageous Effects

According to the present invention, the provision of the stem including the insulating first plate-shaped member and the conductive second plate-shaped member eliminates the need to perform special insulation treatment on the CAN type optical module, and makes it possible to easily take out a signal ground from the lead terminals. Consequently, a stress exerted on the optical module can be eliminated and the mounting into an optical interface can be achieved with high accuracy.

### Brief Description of Drawings

Fig. 1 is a side sectional view showing a schematic configuration of a CAN unit of a CAN type optical module according to an exemplary embodiment of the present invention;
Fig. 2 is a side sectional view showing an overall configuration example of the CAN type optical module according to this exemplary embodiment;
Fig. 3 is a side sectional view showing a schematic configuration of an optical interface including the CAN type optical module according to this exemplary embodiment installed in an interface (INF) case;
Fig. 4 is a side sectional view schematically showing a structure of a CAN unit in a CAN type optical module according to the background art;
Fig. 5 is a side sectional view showing an overall configuration example of the CAN type optical module according to the background art; and
Fig. 6 is a side sectional view showing a schematic configuration of an optical interface including the CAN type optical module according to the background art installed in an interface (INF) case.

### Explanation of Reference

- 102: OPTICAL COMPONENT
- 103: LENS-EQUIPPED HOLDER PORTION
- 104: BALL LENS
- 106: RESISTANCE WELDING PORTION
- 120: SUPPORT POTION
- 130: RECEPTACLE PORTION
- 140, 141: WELDING PORTION
- 160: OPTICAL MODULE FIXING PORTION
- 200: OPTICAL MODULE
- 201: STEM
- 202: SILVER SOLDERING PORTION
- 203: LEAD TERMINAL
- 210: CAN UNIT
- 250: INF CASE
- 260: OPTICAL MODULE FIXING PORTION
- 270: PRINTED WIRING PORTION (PWB)

### Best Mode for Carrying Out the Invention

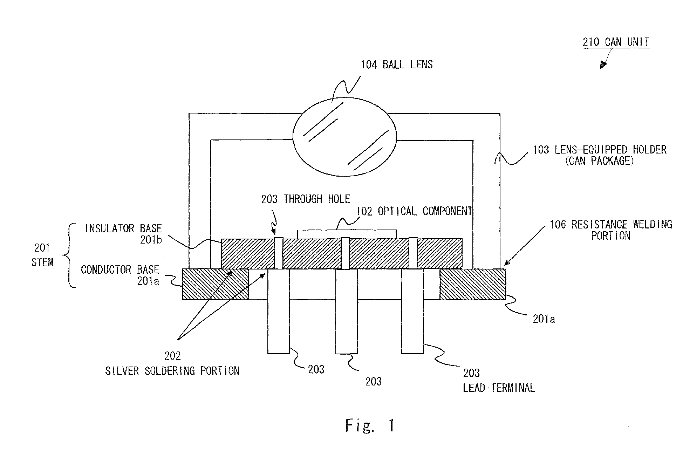

Fig. 1 is a side sectional view showing a schematic configuration of a CAN unit of a CAN type optical module according to an exemplary embodiment of the present invention. Note that components identical with those of an optical module 100 shown in Figs. 4 to 6 are denoted by the same reference numerals.

In a CAN unit 210 shown in Fig. 1, a stem 201 has a configuration in which a doughnut-plate-shaped conductor base 201a made of a conductive material and a disc-shaped insulator base 201b made of an insulating material are fixed to each other. The conductor base 201a has a circular opening formed in the center, and is joined and fixed to the insulator base 201b so as to cover the opening. An optical component 102 composed of an optoelectronic element or the like is mounted on a mounting portion which is provided on the inner surface of the insulator base 201b. The conductor base 201a is made of, for example, a metal, and the insulator base 201b is made of, for example, ceramic.

The doughnut-plate-shaped conductor base 201a is silver-soldered to the disc-shaped insulator base 201 b with a silver soldering portion 202. Specifically, in this example, the diameter of the insulator base 201b is larger than the diameter of the opening of the conductor base 201a. A peripheral portion of the insulator base 201b is silver-soldered so as to close the opening of the conductor base 201a. A peripheral portion of the conductor base 201a is resistance-welded to a lens-equipped holder 103, which serves as a CAN package, with a resistance welding portion 106. The lens-equipped holder 103 is also made of a conductor like a metal, so the conductor base 201a and the lens-equipped holder 103 are electrically connected to each other.

Note that, as described above, a ball lens 104 is mounted to the lens-equipped holder 103 by glass sealing. The ball lens 104 maintains a positional relationship of light beams to be focused on the optical component 102 between the ball lens 104 and the optical component 102. The optical component 102 is composed of optical and electrical circuits including an optoelectronic element for performing conversion between an optical signal and an electrical signal.

Meanwhile, a plurality of lead terminals 203 are fixed to the outer surface of the insulator base 201b. For example, the lead terminals 203 can be mounted to the outer surface of the insulator base 201 b by silver soldering. In addition, the insulator base 201 b has through holes 204 for electrical connection formed therein so as to correspond to the respective lead terminals 203. Specifically, electric wires of the optical component 102 mounted on the inward mounting portion are electrically connected to the lead terminals 203, which extend externally, through the through holes 204.

As shown in Fig. 1, the through holes 204 as well as the lead terminals 203 are formed in the insulator base 201b, and thus are electrically isolated from the conductor base 201a. Accordingly, the entire side surface of the CAN unit 210 can be used as a frame GND, and at least one of the lead terminals 203 can be used as a signal GND terminal. In other words, as described later, the lead terminals 203 extending from the insulator base 201b can be used as the signal GND independently of the frame GND, and can be easily connected to the signal GND of a printed wiring board (PWB) without performing special insulation treatment.

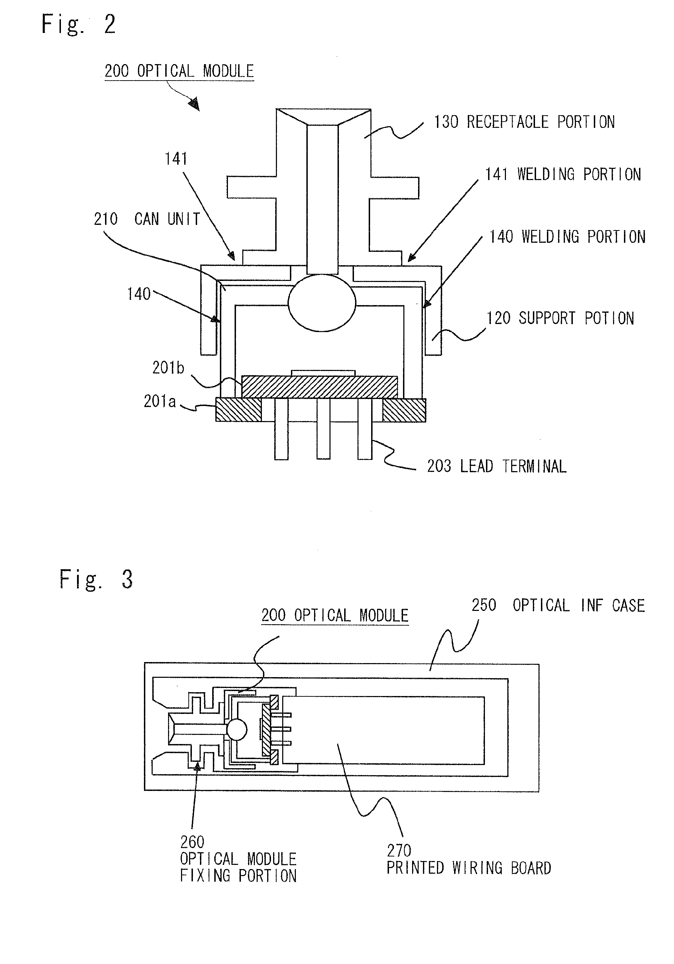

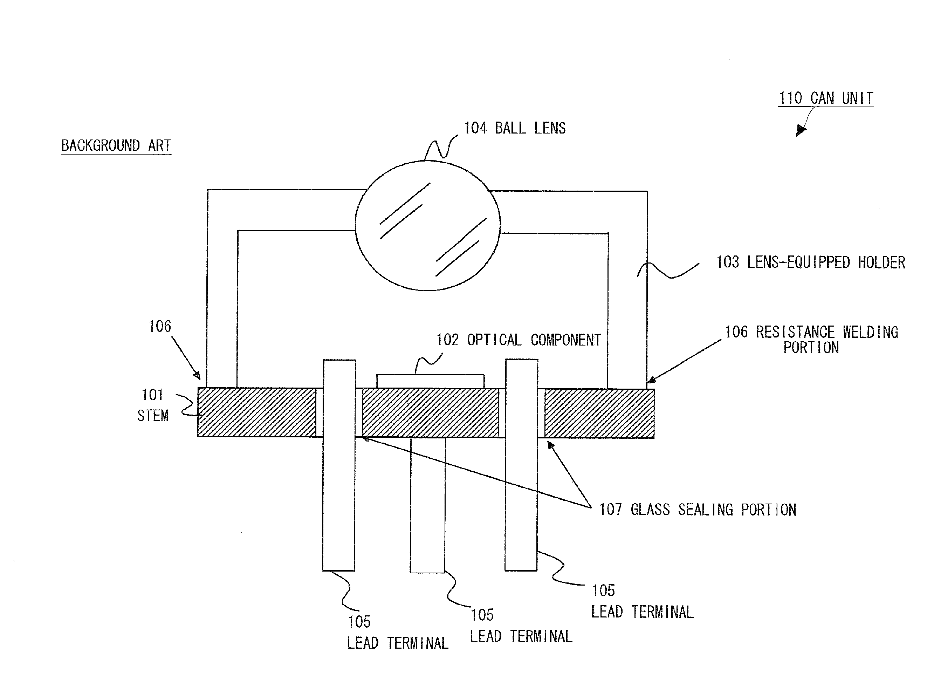

Fig. 2 is a side sectional view showing an overall configuration example of the CAN type optical module according to this exemplary embodiment. A CAN type optical module 200 according to this exemplary embodiment incorporates the CAN unit 210 shown in Fig. 1. The CAN unit 210 is joined by welding to a support potion 120 with a welding portion 140. The support potion 120 is also joined by welding to a receptacle portion130 with a welding portion 141. As described above, since the signal GND is drawn out only by the lead terminal 203, it is electrically isolated from the frame GND of the support potion 120 and the receptacle portion130.

Fig. 3 is a side sectional view showing a schematic configuration of an optical interface including the CAN type optical module according to this exemplary embodiment installed in an interface (INF) case. The optical module 200 fabricated by welding the support potion 120 and the receptacle portion 130 to the CAN unit 210 is installed in an optical INF case 250 through an optical module fixing portion 260. In this case, in the optical module 200, the signal GND is drawn out by the lead terminals 203. Accordingly, a signal terminal and a GNd terminal of the lead terminal 203 can be electrically connected to a printed wiring board 270 without performing special insulation treatment.

Thus, the need for insulation treatment is eliminated in the case of mounting the optical module 200. Accordingly, the mounting can be achieved with high positional accuracy, and variations in mounting position can be suppressed. Moreover, a stress exerted on the optical module 200 due to insulation treatment using an insulating sheet can be suppressed. Therefore, the production of optical interfaces for use in the optical communication filed with high accuracy can be facilitated.

Note that the configurations and operations of the exemplary embodiments described above are illustrated by way of example, and modifications can be appropriately made without departing from the scope of the present invention, as a matter of course.

This application is based upon and claims the benefit of priority from Japanese patent application No. 2007-325399, filed on December 18, 2007, the disclosure of which is incorporated herein in its entirety by reference.

### Industrial Applicability

The present invention is applicable to an electrically insulating structure in an optical module required to have high positional accuracy.

## Claims

1. A CAN type optical module comprising:
a stem including an insulating first plate-shaped member having an optoelectronic element mounted on an inner surface thereof and a conductive second plate-shaped member having an opening and being fixed with the first plate-shaped member so as to cover the opening;
a conductive CAN member fixed to the second plate-shaped member so as to include the optoelectronic element provided on the first plate-shaped member; and
a plurality of lead terminals electrically connected to respective electric wires from the optoelectronic element and fixed to an outside of the first plate-shaped member.

2. The CAN type optical module according to Claim 1, wherein the CAN member is fixed with an optical element optically corresponding to the optoelectronic element.

3. The optical module according to Claim 1 or 2, wherein at least one of the plurality of lead terminals corresponds to a signal ground of the optoelectronic element and is electrically isolated from the CAN member.

4. An optical interface comprising the CAN type optical module as set forth in any one of Claims 1 to 3.
